(19) Europäisches Patentamt European Patent Office Office européen des brevets

(11) **EP 1 820 380 B1**

(12) **EUROPEAN PATENT SPECIFICATION**

(45) Date of publication and mention of the grant of the patent:
**13.02.2013 Bulletin 2013/07**

(21) Application number: **05803699.7**

(22) Date of filing: **18.11.2005**

(51) Int Cl.:
*H05K 3/12* *(2006.01)* *B41N 1/24* *(2006.01)*

(86) International application number:
**PCT/SE2005/001740**

(87) International publication number:
**WO 2006/062457 (15.06.2006 Gazette 2006/24)**

(54) **SOLDER PASTE STENCIL AND METHOD FOR PRODUCING THE SAME**

LOTPASTENRÖHRCHEN UND VERFAHREN ZU SEINER HERSTELLUNG

STENCIL POUR PATE A BRASER ET SON PROCEDE DE PRODUCTION

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.12.2004 SE 0403008**

(43) Date of publication of application:
**22.08.2007 Bulletin 2007/34**

(73) Proprietor: **HP Etch AB**
**Box 567, S-175 26 Jarfalla (SE)**

(72) Inventor: **KILEN, Jan**
**S-118 42, Stockholm (SE)**

(74) Representative: **Ebbinghaus, Marie-Louise**
**Ebbinghaus & Partners AB**
**Frejvägen 17**
**184 92 Åkersberga (SE)**

(56) References cited:
**EP-A2- 1 448 032       WO-A1-03/103353**
**US-A- 5 359 928        US-A- 5 661 086**
**US-A- 5 873 512        US-A1- 2001 046 586**
**US-A1- 2004 121 606**

• **"SCREEN STENCILS WITH IMPROVED RELEASE PROPERTIES", IBM TECHNICAL DISCLOSURE BULLETIN, INTERNATIONAL BUSINESS MACHINES CORP. (THORNWOOD), US, vol. 37, no. 6A, 1 June 1994 (1994-06-01), page 441/442, XP000455838, ISSN: 0018-8689**

**Description**

**Field of the invention**

The present invention concerns a method for producing solder paste stencils according to the preamble of claim 1. Further, it concerns a solder paste stencil according to the preamble of claim 11.

**Background of the invention**

The design of many new electronic products require high density interconnect printed circuit boards, PCB, since these products require more functions on less area to be competitive on the market.

The highly integrated and small components require small and high-density spaced connection pads on the PCB. A typical high density fine line PCB has pads down to approximately 0,25 mm, in width and a minimum spacing of 0,4 mm.

To solder a joint between the board-pad and the component termination, solder paste is applied onto all the pads on the board. To apply the solder paste, a stencil is used, the stencil serving as a mask which allows the solder paste to flow down into the stencil holes and reach the board pads.

The stencil is manufactured with one hole for every pad on the board, and the size of the hole is normally approximately 10% smaller than the pad. However, the hole size could also be based on other board requirements. The stencil is applied on top of the board and the holes are lined up with the pads by means of a fixture unit.

The solder paste, which consists of solder particles mixed together with a flux-medium, is distributed on top of the stencil with a squeegee or a hermetic printing head.

**Prior art**

There are several different ways to manufacture a solder paste stencil for fine line boards. The three most common are:

1. The stencil is made from a metal sheet and the holes are cut out by high precision chemical etching in one operation.
2. The stencil is made from a metal sheet and a laser is used to cut out the holes one by one.
3. The stencil is built up by electro-forming, which normally results in a high quality stencil.

It is more cost efficient to use a metal sheet with a thickness of approximately 0.15 mm and to cut out the holes (methods 1 and 2 above), than to build up the stencil by electro-forming (method 3 above).

A typical stencil thickness is approximately 0,08 to 0,2 mm, possibly with a varying thickness, sometimes named a multilevel stencil.

The use of stencils for fine line boards may involve some problems; when the stencil is separated from the board, a relatively large portion of the solder paste may stick to the inside walls of the hole, and too little paste is left on the pads to form a good solder joint. Further, the paste that is left on the stencil will contaminate the next board to be printed, resulting in high waste of boards and a need for frequent cleaning of stencils.

Until today, stencil manufactures have tried to solve these problems in two ways, the first one being to adapt the proportion between the stencil hole area and the stencil thickness. The following is a known empiric mathematical relation between the stencil hole area and the surface area of the inside walls of the hole which must be upheld to minimize sticking:

$$\textit{Area of hole / surface area of inside hole walls} \geq \textit{2/3.}$$

However, reducing the thickness of the stencil, and thus the surface area of the inside hole walls, is only feasible to a certain extent. When the pattern of the board gets very small or dense and sticking is remedied according to the above relation by decreasing the thickness of the stencil, this results in too small an amount of solder paste being applied. This will result in defective solder joints.

The second way to tackle the problems is to clean stencils between uses. The more paste that sticks to the stencil, the more often it has to be cleaned. However, cleaning increases manufacturing times and adds an extra step in production, rendering the final product more expensive. Also, the mere cleaning will not solve the core problem with too little solder paste being applied.

Examples of solder paste stencils according to the preamble of claim 1 are known from documents WO-A1-2003/103353, US-A1-2001/046586, US-A-5359928, US-A-5873512.

## Object of the invention and its most important features

It is an object of the present invention to solve or reduce the above mentioned problems of the prior art. A main object is consequently to devise a method for producing stencils with improved solder paste release characteristics.

According to the invention, this is achieved by a method having the features defined in claim 1 and by a solder paste stencil having the features defined in claim 5, respectively.

The stencils are made of a sheet material and have two opposite sides, viz. a first side, to be brought into contact with a printed circuit board, PCB, in use and a second side, on which a solder paste is applied in use. To facilitate solder paste to be applied to the PCB, the stencil is formed with at least one through hole, possibly several or a multitude of holes, extending from the first side to the second side.

According to the method of the invention, the stencils are formed with a low surface energy material on a surface layer of the walls of the holes. Forming the walls with a low surface energy material minimizes solder sticking to the wall and thus enhances solder release characteristics. The surface layer of the first side is also furnished with the low surface energy material.

The low surface energy material includes at least one material selected from the group consisting of: Titanium, Nickel, Phosphorus, PTFE, as well as combinations and alloys of these materials.

One possible method to form stencils with a low surface energy material is coating, for instance with a surface layer thickness of about 3-10 $\mu$m.

A modified method to form stencils with a low surface energy material is to use a stencil sheet material which is constituted by said low surface energy material. Thus, in this case, the sheet material is a solid low energy material.

To further improve the release characteristics of the stencils, the method according to the invention may include the step of chemical etching. In this step, etching is carried out from two directions with different etching pressures, preferably with a pressure difference of 5-15%, in particular about 10%, so as to form the hole with a larger opening on the first side than on the second side, resulting in inclined walls of the hole. The walls could for instance be etched to an inclined angle of 2-4 degrees.

The invention also provides a solder paste stencil which can be produced by the above method. It is thus made of a sheet material and has a first side, a second side and at least one through hole, possibly several or a multitude of holes, extending from said first side.to said second side. In order to improve release characteristics of the stencil, at least a surface layer of at least the walls of the holes includes a low surface energy material. Additionally, at least the surface layer of the first side includes a low surface energy material.

## Brief description of the drawings

Embodiments exemplifying the invention will now be described, with reference of the appended drawings, on which

fig. 1 illustrates, in section, a stencil according to the invention, applied to a PCB,
fig. 2 illustrates, in cross-section, another embodiment of a stencil according to the invention,
fig. 3 illustrates, in cross-section, a third embodiment of a stencil according to the invention, and
fig. 4 illustrates etching a through hole from both sides of a stencil, according to the invention.

## Detailed description of the invention

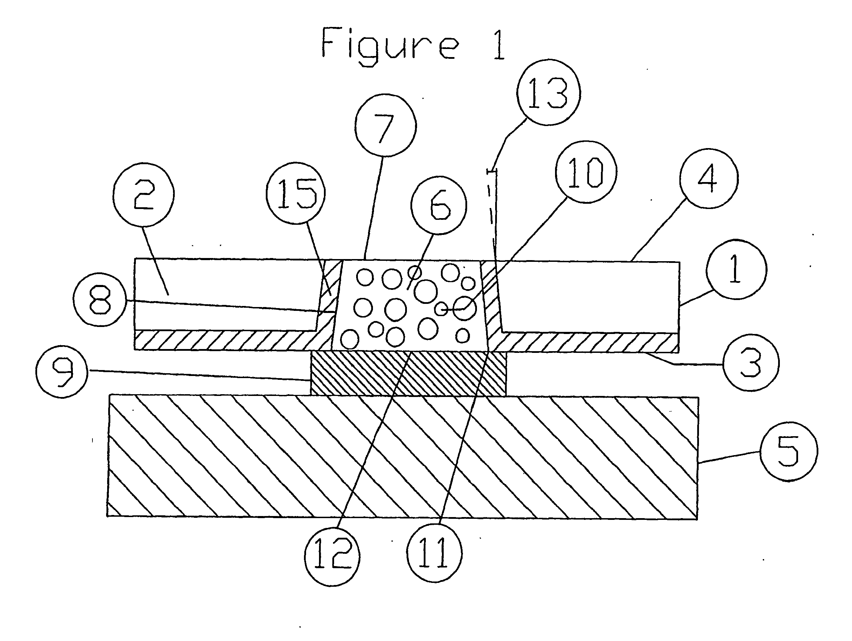

Fig. 1 illustrates schematically in cross-section a stencil 1, made of a sheet material 2, which according to the invention can be a metal or a synthetic material. The stencil 2 has a first side 3 to be brought into contact with a printed circuit board 5, PCB, in use and a second side 4, on which a solder paste 6 is applied in use. To facilitate application of solder paste 6 onto the PCB 5, the stencil is formed with at least one through hole 7, possibly several or many holes, extending from the first side 3 to the second side 4. The solder paste 6 is distributed over the stencil 1 and into the holes 7 of the stencil 2 by means of a squeegee. The squeegee is typically made of a metal material.

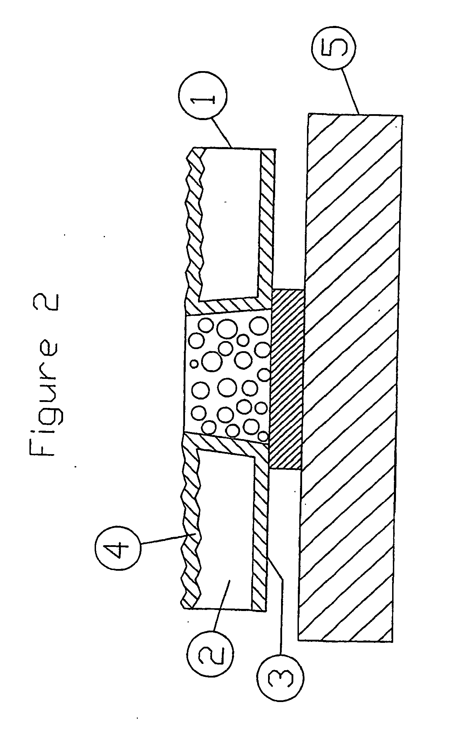

According to the method of the invention, the stencil 1 is formed with a low surface energy material on at least a surface layer 15 of the inside walls 8 of the holes. It is possible to additionally furnish at least the surface layer of at least one of the first 3 and second 4 surfaces, possibly both, with the low surface energy material (Fig. 2). However, if the second surface 4 is formed with a low surface energy material it will be necessary to inhibit the solder paste to slide on top of the stencil. Otherwise, the holes of the stencil will not be properly filled. To remedy this, the second surface 4 should be formed with a wave-like or nonplanar surface pattern, so as to make the solder paste roll (and not slide) over the second surface. Because of the irregular movement of the paste, the holes will be filled better.

It is important to fill the holes in the stencil fully to enable a good solder joint between the board-pad and the component termination.

The low surface energy material can be any material that has sufficiently low surface energy compared to the surface energy of the desired solder paste, in order to minimize the paste wetting the material and thus sticking. Such a low surface energy material may include at least one material selected from the group consisting of: Titanium, Nickel, Phosphorus, PTFE as well as combinations and alloys based on these materials.

One possible method to form stencils with a low surface energy material is coating. After the manufacturing of holes 7 by, for instance, etching or laser cutting in the sheet material 2, a protective cover (not shown) is applied onto the second side 4 of the stencil 1, whereupon the stencil 1 is coated with the low surface energy material, to a thickness of about 3 to 10 μm. The coating material will lower the surface energy and increase the release characteristic of the walls of the holes. Finally, the protective cover on the stencil is removed and the stencil is ready for use.

It is also possible to coat the entire stencil 1 in which case no protective covers are needed (Fig. 2).

Another approach is to apply a protective cover on both sides of the metal sheet and to provide, at least on one side, the protective cover with an opening for every hole. In this way, only the walls of the holes will be coated, and after removing both covers the stencil is ready for use (not shown).

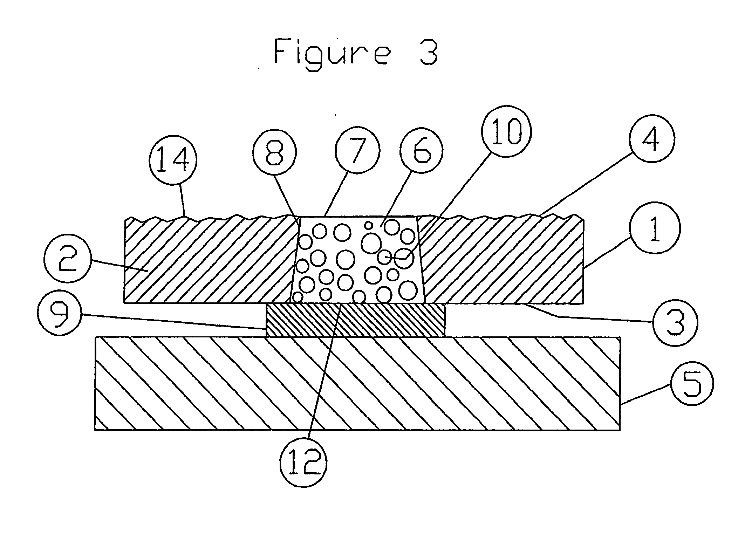

Fig. 3 illustrates another method according to the invention to form stencils with a low surface energy material, by using a stencil sheet material which is constituted by said low surface energy material. In this case, the sheet material is a solid low energy material in which the holes are taken out, and no coating is needed.

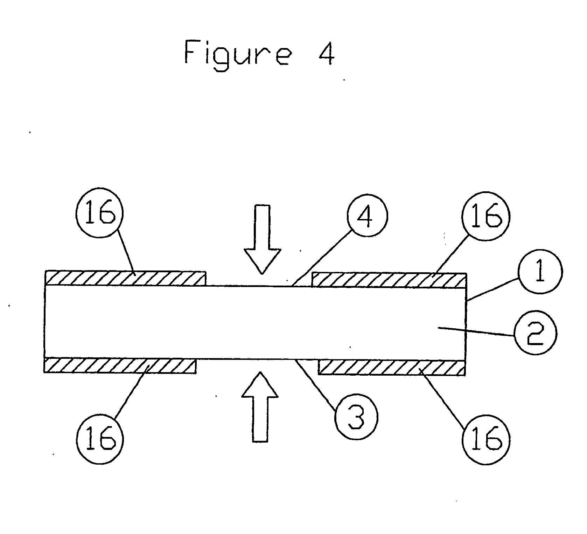

To further reduce the problem of solder paste sticking and to improve the release characteristics of the stencils, a method according to the invention may include a step of high precision chemical etching for producing inclined walls of the holes of the stencil. Such inclined walls promote a better solder paste release from the stencil. In order to achieve inclined walls, holes are etched from both sides of the stencil, indicated with arrows in fig. 4, with a difference in etching pressures between the both sides. This difference could for instance be about 5-15%. Areas 16 denote etching masks covering regions of the stencil not to be etched. A combination of etch pressure difference, fine line etching machines, e.g. from the manufacturer Hoemueller, and the upholding of etchant (ferric chloride) with high chloride ion content provides for accurate etching of inclined walls. With this etch pressure control the hole opening on the first side 3 can be made 10 to 20 μm larger than on the second side 4. If the metal sheet thickness is 0,15 mm, the difference between the areas of the openings corresponds to an inclined angle of 2 to 4 degrees per side. Such an optimal inclined angle is advantageous, since with straight walls, the amount of paste that will stick to the walls of holes will be much higher upon separating the stencil from the board.

By using high precision chemical etching, it is possible to maintain an optimal inclined angle and to receive a fine surface finish and good surface smoothness on the walls of the holes. Etching will also give sharp corners between the etched hole walls and the first and second surfaces of the stencil, without any extra operation.

However, if the inclined angle increases too much, the surface area of the inside walls starts to increase and the quotient between hole area and hole inside wall surface area will decrease. Too big an inclined angle will result in the stencil holes on the second side 4 becoming considerably smaller than on the first side 3, and thus it will be difficult to fully fill the holes with solder paste.

The invention also provides a solder paste stencil as such which can be produced by the above method. It is thus made of a sheet material and has a first side, a second side and at least one through hole, possibly several or many holes, extending from said first side to said second side. In order to improve the release characteristics of the stencil, at least a surface layer of at least the walls of the holes includes a low surface energy material. Additionally, at least the surface layer of at least one of the first side and the second side could include a low surface energy material.

Using a standard stencil with no inclined angle for improved release and no low surface energy material, the area of the walls of holes can be at most 1,5 times larger than the contact area between the solder paste 6 and the pad 9. With the improvements according to the invention, the total surface area of hole walls can be up to two times larger, which enables manufacturing of stencils used for boards with smaller pads and higher density interconnections.

## Claims

1. A method for producing a solder paste stencil (1), said stencil being made of a sheet material (2) and having a first side (3), to be brought into contact with a printed circuit board (5), PCB, in use, and a second side (4), on which a solder paste (6) is applied in use, said stencil being formed with at least one through hole (7) extending from said first side (3) to said second side (4), **characterised in**:

   coating only the walls (8) of said at least one hole (7) and the first side (3) with a surface layer of a low surface energy material, which includes at least one material selected from the group consisting of: Titanium, Nickel, Phosphorus, PTFE, and combinations and alloys of these materials.

**2.** A method according to claim 1, **characterised in**:

- coating with a surface layer thickness of about 3-10 $\mu$m.

**3.** A method according to claim 1 or 2, wherein said at least one hole being formed by high precision chemical etching, **characterised in:**

- **that** the high precision chemical etching is carried out from two opposite directions with different etching pressures so as to form the hole (7) with a larger opening on said first side (3) than on said second side (4), resulting in inclined walls (8) of the hole, wherein the pressure difference is 5-15%.

**4.** A method according to claim 3, **characterised in**:

- etching the walls (8) to an inclined angle of 2-4 degrees.

**5.** A solder paste stencil (1), said stencil (1) being made of a sheet material (2) and having a first side (3), to be brought into contact with a printed circuit board (5), PCB, in use, and a second side (4), on which a solder paste (6) is applied in use, said stencil being formed with at least one through hole (7), extending from said first side (3)to said second side (4), **characterised in that** only the walls (8) of said at least one hole (7) and said first side (3) are coated with a surface layer (15) of a low surface energy material, which includes at least one material selected from the group consisting of: Titanium, Nickel, Phosphorus, PTFE and combinations and alloys of these materials.

**6.** A solder paste stencil according to claim 5, **characterised in that** said at least one through hole (7) has inclined walls (8) with a larger opening on said first side (3) than on said second side (4).

**Patentansprüche**

**1.** Verfahren zum Herstellen einer Lötpastenschablone (1), wobei die Schablone aus einem Flachmaterial (2) hergestellt wird und eine erste Seite (3) aufweist, die bei Gebrauch mit einer Leiterplatte (5), PCB, in Kontakt zu bringen ist, sowie eine zweite Seite (4) aufweist, auf die bei Gebrauch eine Lötpaste (6) aufgetragen wird, wobei die Schablone mit mindestens einem Durchgangsloch (7) ausgeführt wird, das sich von der ersten Seite (3) zur zweiten Seite (4) erstreckt, **gekennzeichnet durch**: Überziehen nur der Wände (8) des mindestens einen Lochs (7) und der ersten Seite (3) mit einer Oberflächenschicht aus einem Material niedriger Oberflächenenergie, das mindestens ein Material umfasst, welches aus der Gruppe bestehend aus Titan, Nickel, Phosphor, PTFE und Kombinationen und Legierungen dieser Materialien gewählt ist.

**2.** Verfahren nach Anspruch 1, **gekennzeichnet durch**:

- Überziehen mit einer Oberflächenschichtdicke von etwa 3-10 $\mu$m.

**3.** Verfahren nach Anspruch 1 oder 2, wobei das mindestens eine Loch durch chemisches Hochpräzisions-Ätzen gebildet wird, **dadurch gekennzeichnet:**

- **dass** das chemische Hochpräzisions-Ätzen von zwei entgegengesetzten Richtungen mit unterschiedlichen Ätzdrücken durchgeführt wird, um das Loch (7) mit einer größeren Öffnung auf der ersten Seite (3) als auf der zweiten Seite (4) zu bilden, mit dem Ergebnis schräger Wände (8) des Lochs, wobei der Druckunterschied 5-15 % beträgt.

**4.** Verfahren nach Anspruch 3, **gekennzeichnet durch**:

- Ätzen der Wände (8) auf einen Neigungswinkel von 2-4 Grad hin.

**5.** Lötpastenschablone (1), wobei die Schablone (1) aus einem Flachmaterial (2) hergestellt ist und eine erste Seite (3) aufweist, die bei Gebrauch mit einer Leiterplatte (5), PCB, in Kontakt zu bringen ist, sowie eine zweite Seite (4) aufweist, auf die bei Gebrauch eine Lötpaste (6) aufgetragen wird, wobei die Schablone mit mindestens einem Durchgangsloch (7) ausgeführt ist, das sich von der ersten Seite (3) zur zweiten Seite (4) erstreckt, **dadurch gekennzeichnet, dass** nur die Wände (8) des mindestens einen Lochs (7) und die erste Seite (3) mit einer Oberflächenschicht (15) aus einem Material mit niedriger Oberflächenenergie überzogen sind, das mindestens ein Material umfasst, welches aus der Gruppe bestehend aus Titan, Nickel, Phosphor, PTFE und Kombinationen und Legierungen dieser Materialien ausgewählt ist.

**6.** Lötpastenschablone nach Anspruch 5, **dadurch gekennzeichnet, dass** das mindestens eine Durchgangsloch (7) schräge Wände (8) mit einer größeren Öffnung auf der ersten Seite (3) als auf der zweiten Seite (4) aufweist.

**Revendications**

**1.** Procédé pour produire un pochoir pour pâte à braser (1), ledit pochoir étant réalisé avec un matériau en feuille (2) et ayant un premier côté (3) destiné à être mis en contact avec une carte de circuit imprimé (5), PCB, à l'usage, et un second côté (4) sur lequel une pâte à braser (6) est appliquée, à l'usage, ledit pochoir étant formé avec au moins un trou traversant (7) s'étendant dudit premier côté (3) audit second côté (4), **caractérisé par** l'étape consistant à :

recouvrir uniquement les parois (8) dudit au moins un trou (7) et le premier côté (3) avec une couche de surface d'un matériau à faible énergie superficielle, qui comprend au moins un matériau choisi dans le groupe comprenant : le titane, le nickel, le phosphore, le PTFE et les combinaisons et les alliages de ces matériaux.

**2.** Procédé selon la revendication 1, **caractérisé par** l'étape consistant à :

- recouvrir avec une épaisseur de couche superficielle d'environ 3 à 10 $\mu$m.

**3.** Procédé selon la revendication 1 ou 2, dans lequel ledit au moins un trou est formé par décapage chimique à haute précision, **caractérisé en ce que** :

- le décapage chimique à haute précision est réalisé à partir de deux directions opposées avec des pressions de décapage différentes afin de former le trou (7) avec une plus grande ouverture sur ledit premier côté (3) que sur ledit second côté (4), se traduisant par des parois (8) inclinées du trou, la différence de pression étant de 5 à 15 %.

**4.** Procédé selon la revendication 3, **caractérisé par** l'étape consistant à :

- décaper les parois (8) sur un angle incliné de 2 à 4 degrés.

**5.** Pochoir pour pâte à braser (1), ledit pochoir (1) étant réalisé à partir d'un matériau en feuille (2) et ayant un premier côté (3) destiné à être amené en contact avec une carte de circuit imprimé (5), PCB, à l'usage, et un second côté (4) sur lequel une pâte à braser (6) est appliquée à l'usage, ledit pochoir étant formé avec au moins un trou traversant (7), s'étendant dudit premier côté (3) audit second côté (4), **caractérisé en ce que** seules les parois (8) dudit au moins un trou (7) et dudit premier côté (3) sont recouvertes avec une couche de surface (15) d'un matériau à faible énergie superficielle, qui comprend au moins un matériau choisi dans le groupe comprenant : le titane, le nickel, le phosphore, le PTFE et les combinaisons et les alliages de ces matériaux.

**6.** Pochoir pour pâte à braser selon la revendication 5, **caractérisé en ce que** ledit au moins un trou traversant (7) a des parois inclinées (8) avec une plus grande ouverture sur ledit premier côté (3) que sur ledit second côté (4).

Figure 1

Figure 2

Figure 3

Figure 4

**EP 1 820 380 B1**

**REFERENCES CITED IN THE DESCRIPTION**

**Patent documents cited in the description**

- WO 2003103353 A1
- US 2001046586 A1
- US 5359928 A
- US 5873512 A